# EUROPEAN PATENT SPECIFICATION

(11) **EP 2 749 155 B1**
(45) Date of publication and mention of the grant of the patent: **08.07.2015**
(21) Application number: 12762411.2
(22) Date of filing: 22.08.2012
(51) Int. Cl.: H05K 1/11, H05K 1/18, H05K 1/05

(54) **WIRING BOARD IN WHICH A COMPONENT IS MOUNTED**
LEITERPLATTE IN DER EIN BAUELEMENT MONTIERT IST
CARTE DE CÂBLAGE DANS LAQUELLE EST MONTÉ UN COMPOSANT

(30) Priority: 22.08.2011 JP 2011180422
(43) Date of publication of application: 02.07.2014
(73) Proprietor: Yazaki Corporation, Minato-ku Tokyo 108-8333 (JP)
(72) Inventor: TAKAGI, Yusuke, Makinohara-shi Shizuoka (JP)
(74) Representative: Grünecker Patent- und Rechtsanwälte PartG mbB
(86) International application number: PCT/JP2012/071922
(87) International publication number: WO 2013/027856

(56) References cited:
- EP-A1- 0 970 594
- DE-B- 1 074 683
- US-A- 4 254 448
- US-A- 4 688 867

## Description

### Technical Field

The present invention relates to a wiring board on which an electric component or an electronic component is mounted as interior components and, more particularly, a wiring board using a metal core substrate in which a metal plate is sandwiched by insulating layers.

### Background Art

A metal core substrate has hitherto been available as a wiring board on which various electric components or electronic components are to be mounted. In the metal core substrate, an insulating layer is provided on each of a top surface and a bottom surface of a metal core made of a metal plate, and a wiring layer (a conductive layer) is laminated on each of the insulating layers. In the metal substrate, a heat generated by the electric component or the electronic components is well dissipated by the metal core (see; for instance, PTL 1).

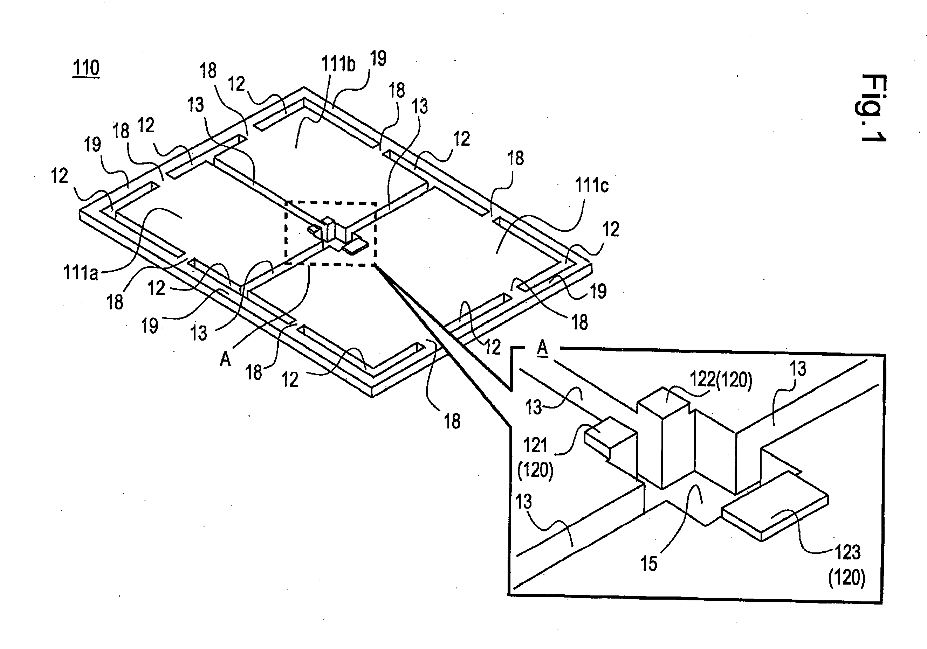

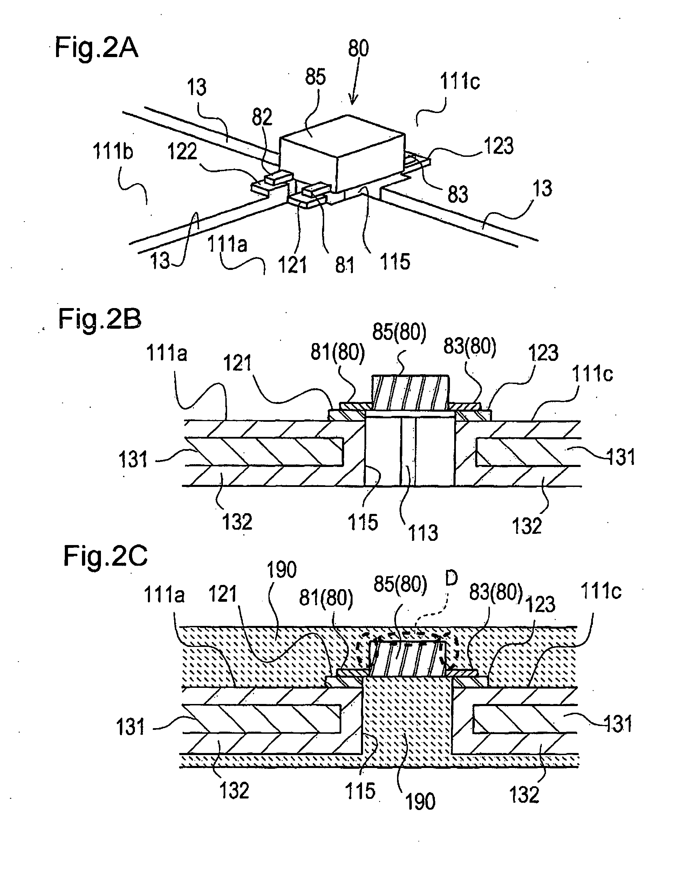

Fig. 1 shows a perspective view of a base substrate 110 that is a metal core substrate on which the electronic components can be mounted. Figs. 2A to 2C show exemplary placement in which an electronic component 80 which is an FET (Field Effect Transistor) is mounted on a component mounting pad. A packaged electronic component 80 such as that shown in Figs. 2A and 2B is attached onto the base substrate 110 as an interior component. Moreover, an insulating layer 190, or the like, is laminated over the electronic component 80 as shown in Fig. 2C, whereby the wiring board is configured.

Specifically, the base substrate 110 is composed of a component mounting pad 120 placed at a center of the base substrate; first to third wiring areas 111a to 111c that are separated into three areas by means of inner grooves 13; and an outer circumferential frame 19 provided outside of outer circumferential grooves 12. Interconnection parts 18 are placed between the outer circumferential frame 19 and the first to third wiring areas 111 a to 111 c so as to bridge the outer circumferential grooves 12. First to third pads 121 to 123 on which first to third terminals 81 to 83 of the electronic component 80 are to be respectively mounted are formed so as to be convexly protruded.

More specifically, as shown in Figs. 2A to 2C, the component mounting pad 120 is formed at a position corresponding to shapes of the first to third terminals 81 to 83 of the electronic component 80 around a component placement opening 115 penetrating through the base substrate 10. A metal core 131 is provided within the base substrate 110. Insulating layers 132 are laminated such that the metal core 131 is sandwiched by the insulating layers 132. Moreover, the component mounting pad 120 and other wiring patterns are formed on a top-side insulating layer 132. The illustration only shows the component mounting pad 120. As shown in Figs. 2A and 2B, the first to third terminals 81 to 83 protruding from lower sides of respective side surfaces of a component body 85 are mounted on and connected to the respective first to third pads 121 to 123. After completion of placement of the terminals, a predetermined number of insulating layers 190 and conductive layers are formed as shown in Fig. 2C by means of lamination processing, or the like, whereby a wiring board is fabricated.

### Citation List

### Patent Literature

### [PTL 1] JP-A-2004-31730

Document EP-B1-0970594 discloses a wiring board as defined in the preamble of claim 1.

### Summary of Invention

### Technical Problem

Incidentally, as mentioned above, the component mounting pad 120 that is part of a conductive layer (an inner layer conductor) assumes a protruded shape such as a trapezoidal shape. Therefore, when the electronic component 80 is mounted on an inner conductor; more specifically, when the electronic component 80 is further covered with the insulating layer 190, or the like, after being mounted on the inner conductor, a thickness of the inner conductor (i.e., the component mounting pad 120) and a thickness of the electronic component 80 are added up, which makes it difficult to perform lamination processing. Moreover, the insulating layer 190 is formed over the electronic component 80 in consideration of a thickness of the component body 85, the insulating layer 190 cannot be made thin, which raises a problem of an increase in the entirety of a final board.

### Solution to Problem

The present invention has been made in view of these situations. It is an object of the present invention to provide a technique for solving the problem.

To achieve the above object, according to present invention, there is provided a wiring board as defined in claim 1, comprising a base substrate that is a metal core substrate, and including an opening in which an interior component that is an electric component or an electronic component is to be mounted, and a terminal placement section on which a terminal of the interior component is to be mounted, the terminal placement section being formed around the opening of the base substrate, and inwardly recessed from a surface of the base substrate so that a part of the interior component is to be placed within the opening.

Further, when the interior component is mounted on the terminal placement section, the interior component may be placed so as not to be protruded from the surface of the base substrate.

Moreover, the inner layer product can also include a packaged component.

### Advantageous Effects of Invention

According to the present invention, it is possible to reduce a thickness of a wiring board in which the metal core substrate is used as a base substrate.

### Brief Description of Drawings

Fig. 1 is a perspective view of a related-art base substrate on which an electronic component can be mounted;
Figs. 2A to 2C are views showing exemplary placement of an electronic component on a related-art component mounting pad;
Fig. 3 is a perspective view of a base substrate of the present embodiment on which an electronic component can be mounted;
Figs. 4A to 4C are views showing exemplary placement of an electronic component on the component mounting pad of the present embodiment;
Figs. 5A to 5C are views showing a wiring board of the present embodiment in which the electronic component is mounted on the component mounting pad and in which insulating layers are formed; and
Figs. 6A and 6B are cross sectional views showing an exemplary placement of an electronic component on the component mounting pad of a modification of the embodiment.

### Description of Embodiment

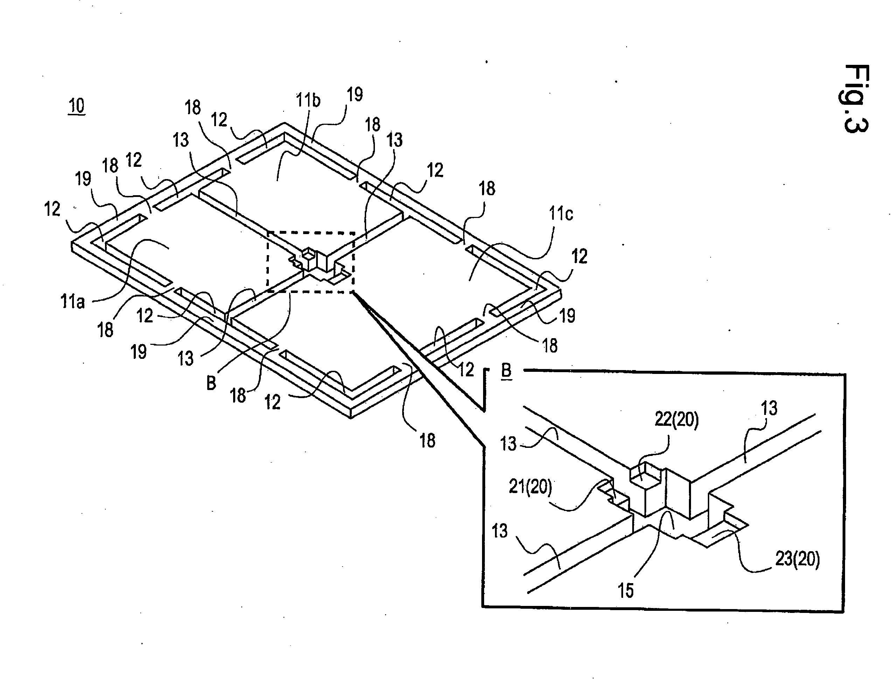

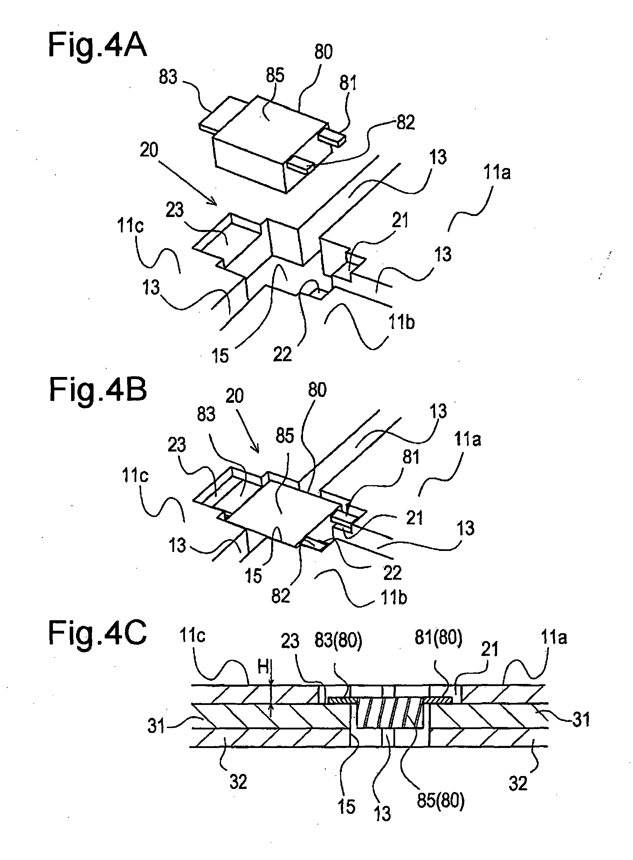

A mode for implementing the present invention (hereinafter referred to as an "embodiment") is hereunder described by reference to the drawings. Fig. 3 is a perspective view of a base substrate 10 of the embodiment, showing in an enlarged manner an area A that is part of the base substrate. A principal difference between the base substrate 10 shown in Fig. 3 and the related-art base substrate 110 shown in Fig. 1 is a component mounting pad 20 (which is corresponded to a terminal placement section in claim). Figs. 4A to 4B show perspective views of the component mounting pad 20 achieved before and after placement of an electronic component 80. Fig. 4C show a cross sectional view of the same after placement of the electronic component 80.

A difference between the illustrated placement and the placement shown in Fig. 2 is that the electronic component 80 is placed upside down. The electronic component 80 is assumed to be a packaged component. Specifically, the electronic component 80 is assumed to be an electronic component that has already been completed as a component.

As shown in Fig. 3, the base substrate 10 is composed of: the component mounting pad 20 placed at a center of an illustrated surface of the base substrate 10; first to third wiring areas 11 a to 11 c separated into three areas by means of inner grooves 13; and an outer circumferential frame 19 located outside of outer circumferential grooves 12. Interconnection parts 18 are provided between the outer circumferential frame 19 and the first to third wiring areas 11 a to 11c so as to bride the outer circumferential grooves 12. A component placement opening 15 vertically penetrating the base substrate is formed in the center of the base substrate 10 where the three inner grooves 13 cross each other.

The component mounting pad 20 is formed around the component placement opening 15 and in an outer edge area of the component placement opening 15. The component mounting pad 20 has first to third pads 21 to 23 on which first to third terminals 81 to 83 of the electronic component 80 are to be respectively mounted. The first to third pads 21 to 23 are formed so as to be inwardly recessed and sunken from the surface of the base substrate 10 in one step. By uncovering a metal core 31 to be described later, the first pad 21 is formed in the first wiring area 11 a; the second pad 22 is formed in the second wiring area 11b; and the third pad 23 is formed in the third wiring area 11c.

As shown in Fig. 4, the metal core 31 is provided within the base substrate 10. The metal core 31 is formed in each of the first to third wiring areas 11a to 11c. A copper plate or an aluminum alloy plate, for instance, is used for the metal core 31. Insulating layers 32 are laminated such that the metal core 31 is sandwiched between the insulating layers 32. Further, various types of wiring patterns (not shown) are formed as inner layer conductors and laminated on the top-side insulating layer 32. In particular, as shown in Fig. 4C, the outer edge area of the component placement opening 15 of the top-side insulating layer 32 is removed by an amount corresponding to a thickness (a depth H) of the insulating layer 32 by means of cutting, etching, or the like, thereby uncovering the metal core 31, whereby the first to third pads 21 to 23 are created.

In the outer edge of the component placement opening 15 that penetrates through the base substrate 10, the first to third pads 21 to 23 of the component mounting pad 20 are formed at positions corresponding to geometries of the first to third terminals 81 to 83 of the electronic component 80. The depth H of the first to third pads 21 to 23 from the surface is set so as to become greater than the thickness of the first to third terminals 81 to 83 of the electronic component 80.

Moreover, when the electronic component 80 is mounted on the component mounting pad 20, the component body 85 is arranged so as to be present within the component placement opening 15. That is, in contrast with the related art electronic component, the electronic component 80 is placed upside down. Therefore, the component placement opening 15 has at least a size and a shape that enable placement therein of the component body 85. Although the component placement opening 15 is herein formed at a point of intersection of the three inner grooves 13, the component placement opening section 15 is not limited to the point of intersection. The component placement opening 15 can also be formed irrespective of the inner grooves 13.

In other word, when the first to third terminals 81 to 83 of the electronic component 80 are mounted respectively at the first to third pads 21 to 23, the first to third terminals 81 to 83 are situated inside without projecting from the surface of the base substrate 10. Although the component body 85 is fully accommodated in the base substrate 10, a part of the component body 85 can also project from the surface, so long as the extent of projection is nominal.

When the electronic component 80 is mounted on the component mounting pad 20, the first to third terminals 81 to 83 projecting from lower sides of the respective side surfaces of the component body 85 are mounted respectively on the first to third pads 21 to 23 upside down so that the first to third terminals 81 to 83 are situated at a side which is close to the surface of the base substrate, whereupon electrical connections are established. At this time, the terminals and the pads can also be soldered or fixed to each other by means of a conductive adhesive as necessary. When the electronic component 80 is embodied as an FET, the first to third terminals 81 to 83 become; for instance, a gate electrode terminal, a source electrode terminal, and a drain electrode terminals, respectively.

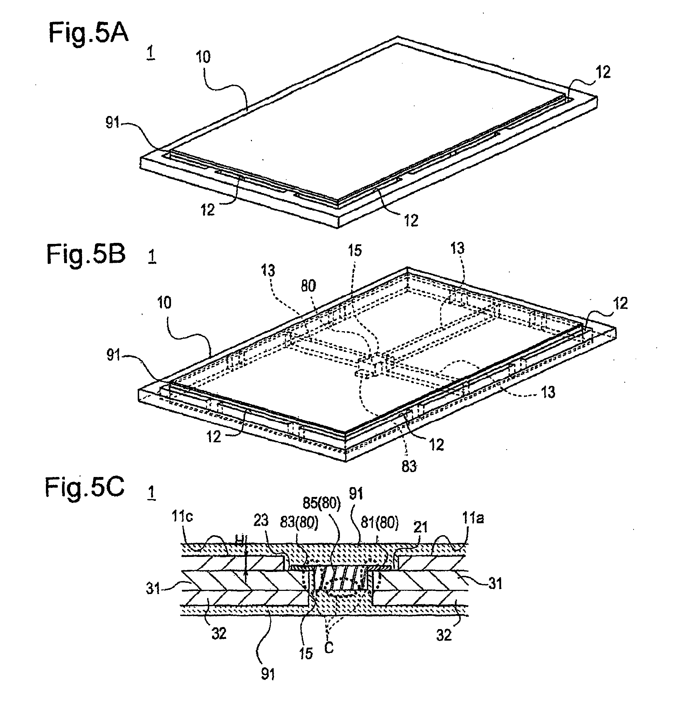

When the electronic component 80 is mounted on the component mounting pad 20 and when other components are mounted at predetermined positions as necessary, an insulating layer 91 that is made of prepreg is laminated on each of the upper and lower surfaces of the base substrate 10 by means of a lamination technique, or the like, as shown in Fig. 5, whereby the wiring board 1 is fabricated. Fig. 5A is a perspective view of the wiring board 1 in which the insulating layer 91 is laminated on the base substrate 10. Fig. 5B is a perspective view showing part of an internal structure shown in Fig. 5A by broken lines. Fig. 5C is also a cross sectional view of an area where the electronic component 80 is mounted on the component mounting pad 20.

A glass cloth impregnated with a thermosetting resin; for instance, an epoxy resin, is used as prepreg of the insulating layer 91. The prepreg is bonded to the base substrate 10 from upper and lower thereof in a vacuum by means of the lamination technique. The thus-bonded base substrate is pressurized and heated, whereupon the thermosetting resin is heated and fused through pressurization and heating, to thus enter spaces, such as the component placement opening 15 and the inner grooves 13, without clearance. Alternatively, the insulating layer 32 of the base substrate 10 can also be formed by means of the lamination technique.

In the embodiment, the electronic component 80 is placed within the component placement opening 15, whereby the thickness of the insulating layer 91 that is prepreg can be reduced. Therefore, a distance from the metal core 31 to the outside becomes shorter, so that a heat dissipation effect of the entire wiring board 1 can be enhanced.

In the related art, as shown in Fig. 2C, when the base substrate is cooled after lamination processing, warpage or a crack often appears in a boundary D between the electronic component 80 and the insulating layer 90. Consequently, degradation of a heat dissipation effect is sometimes deteriorated, or irregularities often appear in an upper surface of the insulating layer 91. Thus, betterment of product yield has hitherto been sought. In particular, when a circuit pattern is laid over the top surface of the insulating layer 91, there is possibility in that the surface treatment is required. When the electronic component 80 is fabricated as part of processing pertaining to a laminating process, a potion of the electronic component 80 equivalent to an outer package (a resin) of the electronic component 80 bears an insulating layer to be laminated, and hence there is a small chance of occurrence of such a problem. However, when a previously packaged electronic component 80 is used, the problem has come to the surface.

However, the electronic component 80 (the component body 85) is placed within the component placement opening 15 in the embodiment; hence, space around the electronic component 80 is small. Accordingly, an amount of insulating layer 91 used for filling surroundings of the electronic component 80 becomes smaller, and occurrence of a significant change in volume of a member of the insulating layer 91, which would otherwise be caused by cooling, is hindered. As a consequence, warpage or a crack can be prevented from appearing in the boundary C (see Fig. 5C) between the electronic component 80 (the component body 85) and the insulating layer 91. Even if warpage or a crack has appeared, an extent of the warpage or crack can be made smaller.

Further, since a distance between the component body 85 and the metal core 31 becomes smaller, transmission of heat given off by the electronic component 80 to the metal core 31 can be improved. Moreover, since the first to third pads 21 to 23 are formed at sunken positions with reference to the insulating layer 32, positioning performed during placement of the electronic component 80 becomes easy.

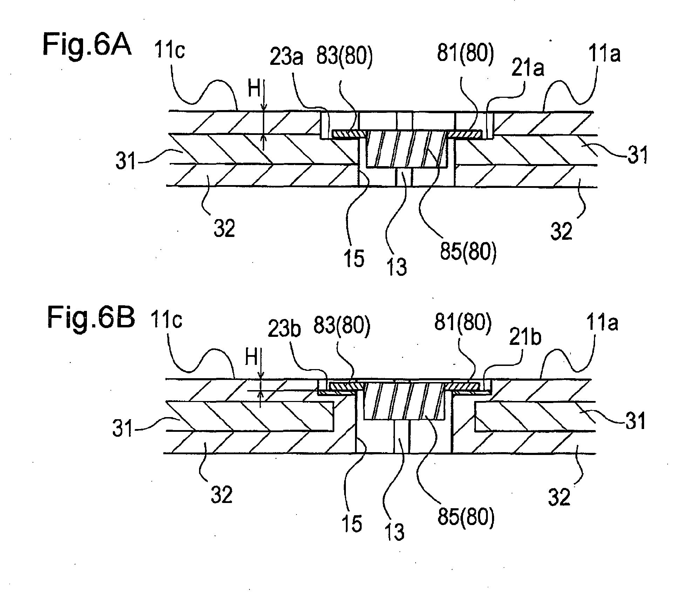

The present invention has been described thus far by reference to the embodiment. The present embodiment is illustrative. Those who are versed in the art will appreciate that constituent elements of the embodiment and their combinations will be susceptible to various modifications and that the modifications will also fall within the scope of the present invention. As shown in; for instance, Fig. 6A, the first to third pads 21a to 23a can also be formed by removing part of the metal core 31 as well as the insulating layer 32. In the case of such a configuration, the metal core 31 will act as part of a wiring circuit. Alternatively, as shown in Fig. 6B, the first to third pads 21b to 21c can also be formed not by uncovering the metal core 31 but by leaving a portion of the top-side insulating layer 32 and etching a conductor, such as copper, put on the thus-left insulating layer 32 in a predetermined pattern to thereby form pads. In the case of such a configuration, the metal core 31 can also be caused to operate as part of a wiring circuit irrelevant to activation of the electronic component 80 or simply as a board cooling structure.

### Industrial applicability

According to the present invention, it is possible to reduce a thickness of a wiring board in which the metal core substrate is used as a base substrate.

### Reference Signs List

1 WIRING BOARD
10 BASE SUBSTRATE
11a FIRST WIRING AREA
11 b SECOND WIRING AREA
11c THIRD WIRING AREA
12 OUTER CIRCUMFERENTIAL GROOVE
13 INNER GROOVE
15 COMPONENT PLACEMENT OPENING
18 INTERCONNECTION PART
19 OUTER CIRCUMFERENTIAL FRAME
20 COMPONENT MOUNTING PAD
21, 21 a, 21 b FIRST PAD
22, 22a, 22b SECOND PAD
23, 23a, 23b THIRD PAD
31 METAL CORE
32 INSULATING LAYER
80 ELECTRONIC COMPONENT
81 FIRST TERMINAL
82 SECOND TERMINAL
83 THIRD TERMINAL
85 COMPONENT BODY
91 INSULATING LAYER

## Claims

1. A wiring board, comprising:
a base substrate (10) including an opening (15) in which an interior component (80) that is an electric component or an electronic component is to be mounted; and
a terminal placement section (20) on which a terminal (81-83) of the interior component is to be mounted, the terminal placement section being formed around the opening of the base substrate, and inwardly recessed from a surface of the base substrate so that a part of the interior component is to be placed within the opening, **characterized in that** the base substrate is a metal core (31) substrate.

2. The wiring board according to claim 1, wherein when the interior component is mounted on the terminal placement section, the interior component is placed so as not to be protruded from the surface of the base substrate.

3. The wiring board according to claim 1 or 2, wherein the interior component includes a packaged component.

## Patentansprüche

1. Leiterplatte, die umfasst:
ein Basis-Substrat (10), das eine Öffnung (15) enthält, in der eine innere Komponente (80) montiert wird, die eine elektrische Komponente oder eine elektronische Komponente ist; und
einen Anschluss-Positionierabschnitt (20), an dem ein Anschluss (81-83) der inneren Komponente montiert wird, wobei der Anschluss-Positionierabschnitt um die Öffnung des Basis-Substrats herum ausgebildet ist und von einer Oberfläche des Basis-Substrats so nach innen eingelassen ist, dass ein Teil der inneren Komponente in der Öffnung positioniert wird,
**dadurch gekennzeichnet, dass** das Basis-Substrat ein Substrat mit Metallkern (31) ist.

2. Leiterplatte nach Anspruch 1, wobei, wenn die innere Komponente an dem Anschluss-Positionierabschnitt montiert ist, die innere Komponente so positioniert ist, dass sie nicht von der Oberfläche des Basis-Substrats vorsteht.

3. Leiterplatte nach Anspruch 1 oder 2, wobei die innere Komponente eine gekapselte Komponente enthält.

## Revendications

1. Carte de câblage, comportant :
un substrat de base (10) comprenant une ouverture (15) dans laquelle un composant intérieur (80) qui est un composant électrique ou un composant électronique doit être monté ; et
une section de placement de borne (20) sur laquelle une borne (81 à 83) du composant intérieur doit être montée, la section de placement de borne étant formée autour de l'ouverture du substrat de base, et renfoncée vers l'intérieur par rapport à une surface du substrat de base de telle sorte qu'une partie du composant intérieur doit être placée dans l'ouverture,
**caractérisée en ce que** le substrat de base est un substrat à âme métallique (31).

2. Carte de câblage selon la revendication 1, dans laquelle quand le composant intérieur est monté sur la section de placement de borne, le composant intérieur est placé de façon à ne pas être amené à dépasser de la surface du substrat de base.

3. Carte de câblage selon la revendication 1 ou 2, dans laquelle le composant intérieur comprend un composant dans un boîtier.
